(19) Europäisches Patentamt / European Patent Office / Office européen des brevets

(11) EP 4 701 067 A1

# (12) EUROPEAN PATENT APPLICATION

(43) Date of publication:
**25.02.2026 Bulletin 2026/09**

(21) Application number: **24196529.2**

(22) Date of filing: **26.08.2024**

(51) International Patent Classification (IPC):
***H02P 1/02*** *(2006.01)* ***G01R 31/34*** *(2020.01)*
***H02P 29/024*** *(2016.01)* ***H02P 29/032*** *(2016.01)*

(52) Cooperative Patent Classification (CPC):
**H02P 1/022; G01R 31/34; G01R 31/343; H02P 29/024; H02P 29/032**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.08.2024 US 202418808539**

(71) Applicant: **Eaton Intelligent Power Limited**
**Dublin 4 (IE)**

(72) Inventors:
- **Gurmeet, Singh**
  **Pune (IN)**
- **Priyabrata, Shaw**
  **Balasore (IN)**
- **Prashanth, A. Telkar**
  **Bangalore (IN)**

(74) Representative: **Schwan Schorer & Partner mbB**
**Patentanwälte**
**Bauerstraße 22**
**80796 München (DE)**

## (54) METHOD TO IDENTIFY ROTOR SLOT HARMONICS IN A MOTOR CURRENT SPECTRUM

(57) A method to identify rotor slot harmonics (RSH) in a motor current spectrum of an AC induction motor includes receiving current data from the motor operated at two different load values, obtaining a motor current frequency spectrum comprising a first motor current spectrum corresponding to a first load value and a second motor current spectrum corresponding to a second load value, detecting a number of peak current values for a frequency range of the motor current frequency spectrum, and comparing the detected number of peak current values for the frequency range from the first motor current spectrum to the second motor current spectrum. Pairs of consecutive peaks are determined from the detected number of peak current values for each of first load value and second load value and compared. When the comparison is above a threshold value, the pair of consecutive peak current values are identified as RSH.

100

130
Variable Frequency Drive 110
120
Power Unit
140
M
Control and
Monitoring
Unit 150
User
Interface
160

FIG. 1

EP 4 701 067 A1

## Description

### BACKGROUND

An induction motor is an alternating current (AC) motor in which the electric current in the rotor that produces torque is obtained by electromagnetic induction from the magnetic field of the stator winding. In an induction motor, rotor slots (openings where conductors are placed) can lead to harmonic components in the stator current waveform. The harmonics are generated due to an interaction between the stator and rotor magnetic fields and are related to the geometry of the rotor slots. Rotor slot harmonic components can be used to estimate the induction motor speed as well as diagnosing faults within the induction motor.

Rotor slot harmonics (RSH) are generally seen in a motor current spectrum. However, in the current spectrum, the detection of the rotor slot harmonics can be difficult due to the presence of other frequency components unrelated to RSH on the motor current spectrum. Additionally, RSH may not be present in the motor current spectrum. RSH typically only exist under certain conditions that depend on the number of poles and rotor bars. Therefore, a more accurate method to identify the rotor slot harmonics in a motor current spectrum is desired.

### BRIEF SUMMARY

A method to identify rotor slot harmonics in a motor current spectrum of an induction motor is provided. Through processes described herein, the rotor slot harmonics of an induction motor can be identified and used to determine the rotor speed of the induction motor as well as diagnose faults in the induction motor.

A computer-implemented method to identify rotor slot harmonics in a motor current spectrum of an AC induction motor includes: receiving current data from the AC induction motor operated at two different load values; obtaining a motor current frequency spectrum comprising a first motor current spectrum corresponding to a first load value and a second motor current spectrum corresponding to a second load value; detecting a number of peak current values for a frequency range of the motor current frequency spectrum; and comparing the detected number of peak current values for the frequency range from the first motor current spectrum to the second motor current spectrum. Comparing the detected number of peak current values for the frequency range from the first motor current spectrum to the second motor current spectrum includes determining a pair of consecutive peak current values from the detected number of peak current values, the pair of consecutive peak current values include a first peak current value for the first load value and a second peak current value for the second load value; calculating a difference between the first peak current value and the second peak current value; comparing the difference to a threshold value; and in response to the difference being greater than zero and less than the threshold value, identifying the pair of consecutive peak current values as rotor slot harmonics.

A method to determine a fault of an induction motor system includes: driving a load by an induction motor; measuring a current of the load driven by the induction motor; estimating a rotor speed of the induction motor; performing a first comparison by comparing the measured current of the load to a baseline load current; performing a second comparison by comparing the estimated rotor speed of the induction motor to a baseline rotor speed wherein the baseline rotor speed is estimated using identified rotor slot harmonics; and determining a fault of the induction motor system based on the first comparison and the second comparison.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF THE DRAWINGS

**FIG. 1** illustrates an operating environment for an induction motor system according to one embodiment.

**FIG. 2** illustrates an operating environment for an induction motor system according to another embodiment.

**FIG. 3** illustrates a flowchart of a method to identify rotor slot harmonics in a motor current spectrum of an induction motor.

**FIG. 4** illustrates a graph of a motor current frequency spectrum of a 10 HP induction motor operated with a DOL soft starter.

**FIG. 5** illustrates a motor current spectrum of 40 HP induction motor operated by a DOL soft starter.

**FIG. 6** illustrates a method depicting a process to determine induction motor system faults using identified RSH.

**FIG. 7** illustrates a schematic diagram illustrating components of a computing device.

DETAILED DESCRIPTION

A method to identify rotor slot harmonics in a motor current spectrum of an induction motor is provided. Through processes described herein, the rotor slot harmonics of an induction motor can be identified and used to determine the rotor speed of the induction motor as well as diagnose faults in the motor. The presented method can be performed to identify the presence of RSH in the current spectrum of an induction motor fed by a fixed frequency, e.g., direct online (DOL) soft starter or a variable frequency drive. Additionally, the presented method can be used for any configuration of motor windings, including star configurations and delta configurations.

Currently, rotor speed estimation is accomplished using different techniques and methods. For example, the rotor speed can be obtained directly using a tachometer coupled to the motor. However, using a tachometer requires access to the motor which can sometimes be difficult, e.g., it resides in a closed housing or resides at a remote location. Additionally, approximation methods such as a straight-line approximation method can be used to estimate rotor speed are simplistic, but not very accurate. There are also complex techniques that are more accurate but are not useful under all conditions. An accurate, simplistic method utilizing the motor current spectrum analysis to identify rotor slot harmonics of an induction motor is presented. The identified RSII can then be used to accurately estimate the speed of the motor or diagnose faults in the motor.

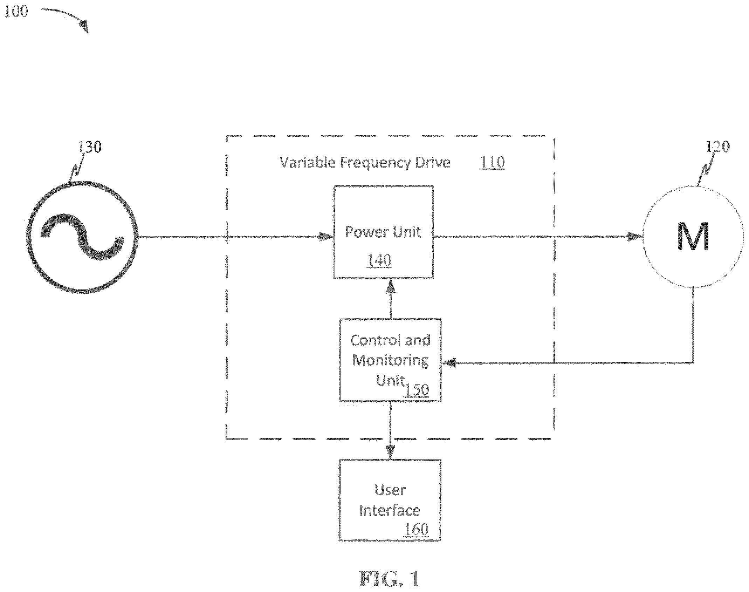

**FIG. 1** illustrates an operating environment for an induction motor system according to one embodiment. Referring to **FIG. 1,** operating environment **100** includes a motor drive **110** and an induction motor **120.** In the illustrated embodiment, the motor drive **110** is a variable frequency drive (VFD). VFD **110** is coupled to a grid **130** that provides the VFD **110** with a three-phase AC power input. VFD **110** includes power unit **140** and a control and monitoring unit **150.** VFD **110** receives the three phase AC input which is fed to power unit **140.** Power unit **140** converts the AC power input to a DC power, inverts and conditions the DC power to a controlled AC power for transmission to AC induction motor **120.** VFD **110** also includes a control and monitoring unit **150** that receives current data from the induction motor **120.** In one embodiment, as illustrated in **FIG. 1,** the control and monitoring unit **150** is integrated into VFD **110.** In other embodiments, control and monitoring unit **150** can be included in an edge device coupled to the VFD or reside in a cloud environment. User interface **160** can be included for communication between the control and monitoring unit **150** and a user.

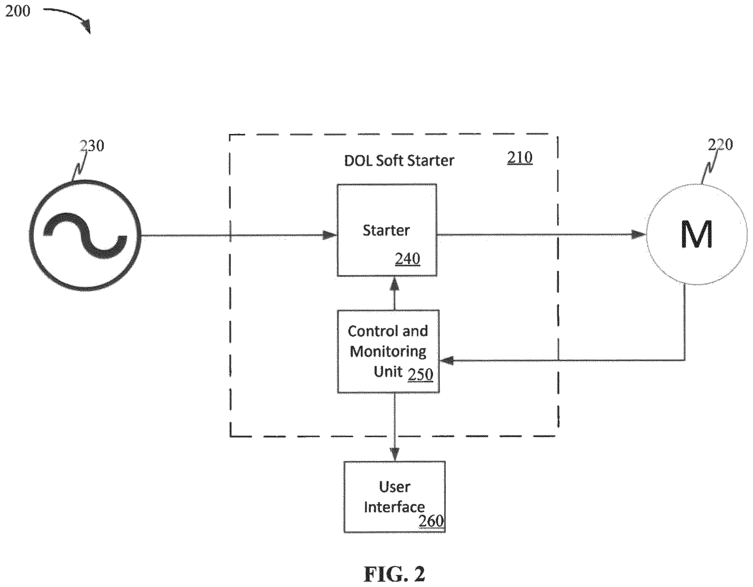

**FIG. 2** illustrates an operating environment for implementing a control and monitoring unit of an induction motor according to another embodiment. Referring to **FIG. 2,** operating environment **200** includes motor drive **210,** e.g., DOL soft starter, and induction motor **220.** The DOL soft starter **210** is coupled to the grid **230.** DOL soft starter **210** includes starter **240** and control and monitoring unit **250.** Starter **240** transmits power between the grid **230** and the induction motor **220.** Similar to the VFD example described previously, DOL soft starter **210** also includes a control and monitoring unit **250** that receives current data from the induction motor **220.** In one embodiment, as illustrated in **FIG. 2,** the control and monitoring unit **250** is integrated into soft starter **210.** In other embodiments, control and monitoring unit **250** can be included in an edge device coupled to the DOL soft starter **210** or reside in a cloud environment. User interface **260** can be included for communication between the control and monitoring unit **250** and a user.

Control and monitoring unit **150, 250** receives motor current data in the form of current signals from the induction motor. Current data can be obtained from current sensors positioned to receive appropriate current signals for motor current analysis. The received motor current data can be used to obtain a motor current spectrum by performing a FFT (Fast Fourier Transform) or other frequency-domain signal processing technique on the received motor current data. In graphical form, the motor current spectrum illustrates the individual spectral components of the current signal providing frequency information about the current signal.

Identifying the rotor slot harmonics of an induction motor mathematically is possible, however, it can be challenging to obtain the required values needed for the calculations. In order to calculate the rotor slot harmonics mathematically, it is first determined whether or not the rotor slot harmonics are present in the motor current spectrum for the induction motor. All induction motors do not exhibit rotor slot harmonic components in their corresponding motor current spectrum. Determining that rotor slot harmonics are present in the motor current spectrum for the induction motor includes determining that an equation:

$$N_R = 2p_p(3\alpha + \kappa) \qquad (1)$$

is satisfied, wherein $N_R$ is a number of rotor bars, $p_p$ is a number of pole pairs, $\alpha$ = 1, 2, 3, ..., and $\kappa$ = -1, 0, 1.

The motor current spectrum is associated with the rotor bar number of the motor. The RSH component in the motor current spectrum is provided as:

$$freq = \left( (kR \pm n_d) \frac{(1-s)}{p_p} \pm v \right) \times f \qquad (2).$$

wherein $n_d$ is the dynamic eccentricity, R is the number of rotor slots, $p_p$ is the number of pole pairs, k is a constant, v is the harmonics 1, 3, 5, ..., f is the supply frequency, and s is motor slip. For a particular loading condition $N_1$, operating the induction motor with current $i_{L1}$, to produce rotational speed $N_1$, it can be seen that the rotor slot harmonics in the motor current spectrum are correlated with the speed of the motor. In an induction motor, the rotor speed rotates at a speed less than the rotating magnetic field of the stator, e.g., the rotational speed. For example, using equation (2) with $n_d = 0$, $v = 1$, and $K = 1$, the slot harmonic frequency can be estimated by:

$$freq1 = \left( (R) \frac{N_1}{p_p \times N_s} \pm 1 \right) \times f \ldots (3).$$

$$freq1_a = \left( (R) \frac{N_1}{p_p \times N_s} + 1 \right) \times f$$

$$freq1_b = \left( (R) \frac{N_1}{p_p \times N_s} - 1 \right) \times f$$

$$\Delta f = freq1_a - freq1_b = 2 \times f \ \ldots (4).$$

Equation (4) illustrates that the sidebands for a given load e.g., $N_1$, has a frequency difference of 2*f*. It can be concluded from equations (3) and (4) that for a given supply frequency *f*, as the load of the motor increases, the RSH change and are therefore load dependent.

The frequency difference between peaks on the motor current spectrum due to different loading conditions $N_1$ and $N_2$ can be calculated as:

$$freq1_{al1} - freq1_{al2} = \left( (R) \frac{N_1}{p_p \times N_s} + 1 \right) \times f - \left( (R) \frac{N_2}{p_p \times N_s} + 1 \right) \times f = \frac{R \times (N_1 - N_2) \times f}{p_p \times Ns}$$

$$= \frac{R \times (N_1 - N_2)}{60}$$

(5).

Based on the above conclusion that the rotor slot harmonics of the frequency are speed dependent, a simplified method is presented in which the only input necessary to perform the method is current data obtained by operating the induction motor at two different load conditions (e.g., rotational speeds).

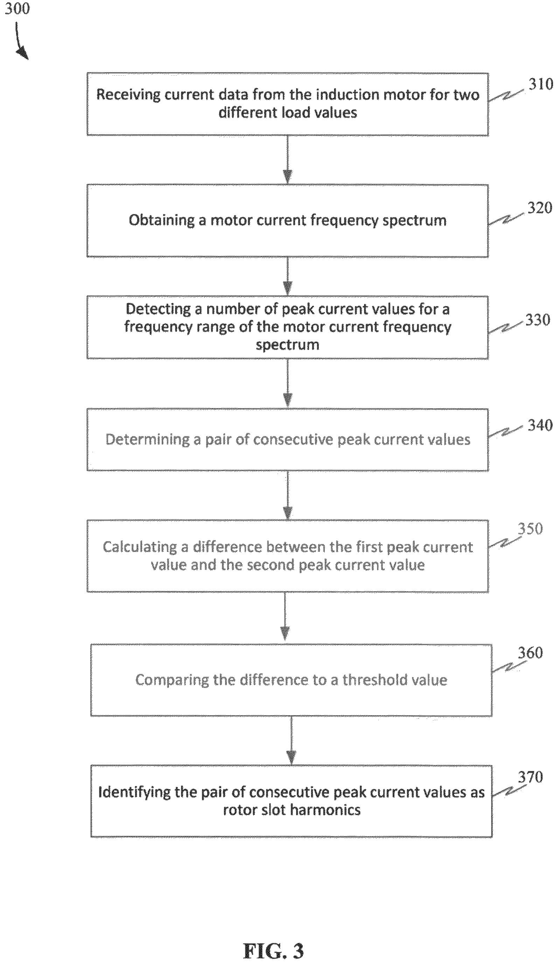

**FIG. 3** illustrates a flowchart of a method to identify rotor slot harmonics in a motor current spectrum of an induction motor. Referring to **FIG. 3,** method **300** begins upon receiving **(310)** current data from the induction motor for two different load values. The induction motor is operated with two different loading conditions, e.g., currents, in and $i_{L2}$ to produce corresponding speeds $N_1$ and $N_2$, in which the current data is captured for the two different load values. A code of method **300** can be integrated into the control and monitoring unit **150, 250.**

Method **300** further includes obtaining **(320)** a motor current frequency spectrum comprising a first motor current spectrum corresponding to a first load value and a second motor current spectrum corresponding to a second load value. The motor current frequency spectrum can be obtained by performing a FFT, or other frequency-domain signal processing technique, on the received current data from the induction motor for the two different load values to produce the first motor current spectrum corresponding to the first load value and the second motor current spectrum corresponding to the second load value.

Method **300** further includes detecting **(330)** a number of peak current values for a frequency range of the motor current frequency spectrum. Detecting the number of peak current values for a frequency range of the motor current frequency spectrum can include calculating a mean value from a plurality of current values within the frequency range and comparing each current value of the plurality of current values to the mean value. When the comparison of the current value is above a threshold value, a peak current value is detected.

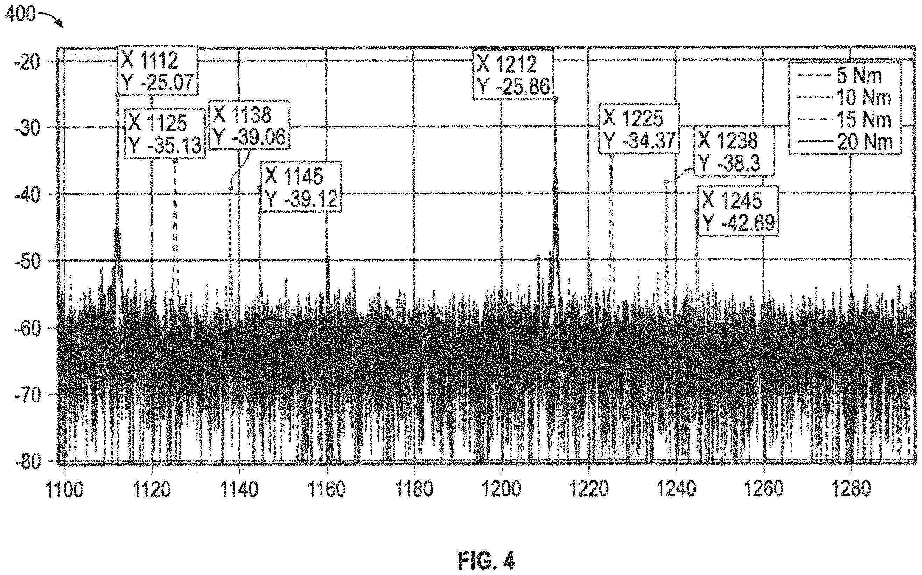

For example, **FIG. 4** illustrates a graph of a motor current frequency spectrum of a 10 HP induction motor operated with a DOL soft starter. Referring to **FIG. 4,** graph **400** illustrates a multitude of different current values displayed for the frequency range on the illustrated graph for four different loading conditions. In order to filter out the meaningful values, e.g., the current peak values, from the current values on the motor current frequency spectrum for a particular frequency range on the graph, a mean value of all the values can be calculated. The values close to the mean value, e.g., below a threshold value, can be removed while only the values above the threshold value are considered as peak current values. The peak current values are easily seen on the graph of **FIG. 4** as they rise above the other values close to a mean value (and are marked with x, y values on the graph).

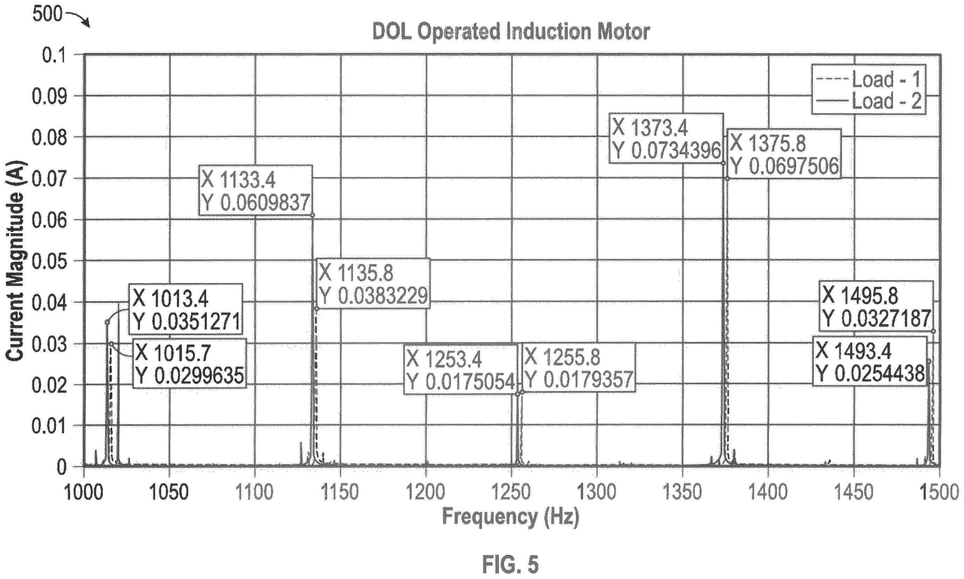

**FIG. 5** illustrates a motor current spectrum of 40 HP induction motor operated by a DOL soft starter. Referring to **FIG. 5,** graph **500** shows a result of detecting the number of current peaks for the frequency range by removing unmeaningful current values e.g., noise. As can be seen in graph **500,** pairs of consecutive peak current values are shown.

The pairs of consecutive peak current values can then be compared to determine whether the current peak values are rotor slot harmonics. Method **300** further includes determining **(340)** a pair of consecutive peak current values. The pairs of consecutive peak current values lie adjacent to one another on the graph, e.g., at frequency values that are close to one another. Each pair of consecutive current peak values includes a first current peak value from the first motor current spectrum corresponding to a first load value and a second current peak value from the second motor current spectrum corresponding to a second load value.

Method **300** further includes calculating **(350)** a difference between the first current peak value and the second current peak value. The difference can then be compared **(360)** to a threshold value. The threshold value can be dependent on the number of rotor poles. In some cases, the threshold can be in a range between 1-20 Hz. When the peak current values are greater than zero and less than a threshold value, the peak current values are identified **(370)** as rotor slot harmonics.

In some cases, once the peak current values have been identified as rotor slot harmonics, a verification computation can be performed. The verification computation can include determining a difference between two consecutive peak current values for the same load value. The two consecutive peak current values for the same load value include the first peak current value for the first load value and a third peak current value for the first load value or the second peak current value for the second load and a fourth peak current value for the second load. When the difference between the consecutive peak current values is two times a supply frequency, it is verified that the identified current peaks are rotor slot harmonics. For example, referring to **FIG. 5,** it can be seen from the that for load 2, there is one peak current value at 1253.4 and a consecutive peak current value at 1373.4. A difference between these two peak current values is 120 Hz which is 2 times the supply frequency of 60 Hz.

In some cases, the identified rotor slot harmonics can be stored on a computer readable storage medium. The stored identified rotor slot harmonics can be used at a later time to estimate the speed of the induction motor or diagnose faults of the motor. In some cases, the stored RSH can be used as a baseline measurement to be used in calculations/estimations of variables indicating an induction motor operating normally. In some cases, the identified RSH components can later be used to determine the remaining useful life (RUL) of the induction motor, for example. In some cases, the stored RSH can be used to estimate a baseline rotor speed, $N_{rb}$. Measuring a difference in a rotor speed from the baseline rotor speed $N_{rb}$ can also determine an anomaly of the induction motor. For example, a change in the value of the identified RSH frequency component indicates a change in the speed of the induction motor. This change in the RSH frequency components with respect to the induction motor operating under the same conditions can indicate an anomaly in the induction motor. The higher the difference of the RSH frequency components from the baseline measurement can correlate to a higher fault severity.

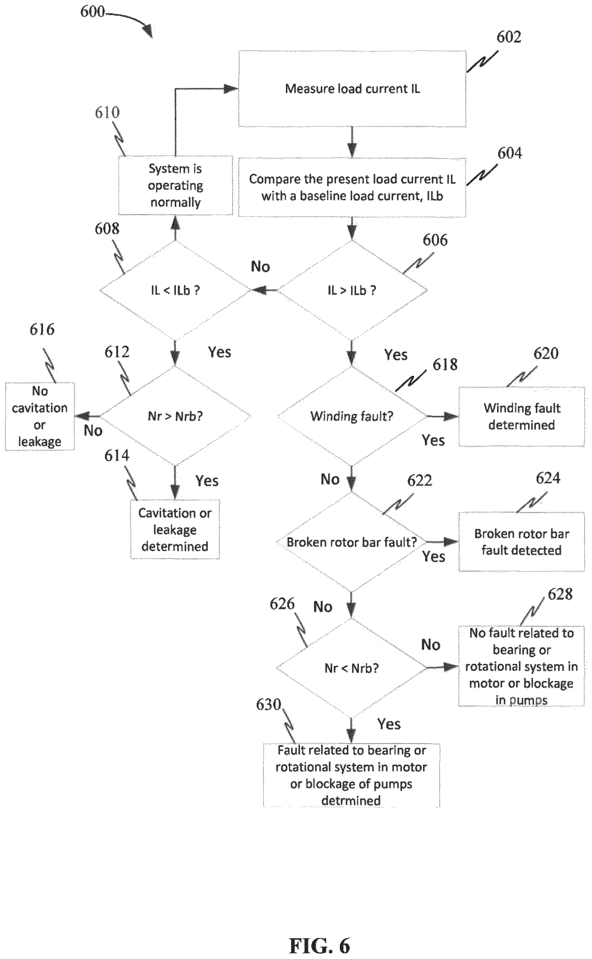

The identified rotor slot harmonics can be used to estimate the rotor speed according to known methods. The estimated rotor speed can then be used to determine a fault in the induction motor or in an induction motor driven system. For example, an induction motor can be used to drive a load, such as a pump or a compressor, creating the induction motor driven system. **FIG. 6** illustrates a flowchart depicting a method to determine induction motor system faults using identified RSH. For example, the rotor slot harmonic components can be used for determination of a winding fault, a broken rotor bar fault, a cavitation fault, a bearing fault, rotational fault, and a pump blockage fault.

Referring to **FIG. 6,** method **600** begins by measuring **(602)** a current of the load, $I_L$. A baseline load current, $I_{Lb}$ and a baseline rotor speed, $N_{rb}$, of the induction motor operated with the same load under the same supply frequency and operating conditions are used in the process. These values can be previously determined and stored in memory. The baseline rotor speed $N_{rb}$ can be estimated using identified rotor slot harmonics from the measured baseline load current determined according to method **300.** The rotor speed $N_r$ is estimated using traditional methods from its frequency information obtained from the motor current spectrum, e.g., by using equation (2). Slip, s, can be back calculated from frequency, f. Nr is then calculated using the slip, s, and synchronous speed $N_s$. The measured load current $I_L$ is first compared **(604)** to the baseline load current $I_{Lb}$. Additionally, the baseline load speed, $N_{rb}$, is then compared (second comparison) to the estimated rotor speed $N_r$. A fault of the induction motor or induction motor system can be determined from these two comparisons.

In some cases, a cavitation or leakage fault of the driven load can be determined. Cavitation in a pump is a condition where the liquid being pumped forms and collapses vapor bubbles due to low pressure. Cavitation and water leakage can be determined in all types of pumps (e.g., centrifugal pump, displacement pump, etc.) Air leakage can be determined in all types of compressors. At the same supply frequency and operating conditions, when the measured load current $I_L$ is less than the baseline load current $I_{Lb}$ (608) and the rotor speed $N_r$ is greater than the baseline load speed $N_{rb}$ (612), a cavitation/leakage fault can be determined (614). If the load current $I_L$ is equal to the baseline load current $I_{Lb}$, the system is operating normally (610). If the rotor speed $N_r$ is not greater than the baseline rotor speed $N_{rb}$, a cavitation/load fault is not determined (616).

In some cases, at the same supply frequency and operating conditions, the load current $I_L$ being greater than the baseline load current $I_{Lb}$ (606) can indicate a winding fault (618) or a broken rotor bar fault (622). After the first comparison indicates a fault (606), a winding fault or a broken rotor bar fault can be determined (620, 624) by a technician using existing methods.

After verifying that there is not a winding fault or a broken rotor bar fault, a pump blockage or rotational system fault can be determined. At the same supply frequency and operating conditions, when the load current $I_L$ is greater than the baseline load current $I_{Lb}$ (606) and the rotor speed $N_r$ is less than the baseline rotor speed $N_{rb}$ (626), a rotational/pump blockage fault can be determined (628). Rotational faults can include issues with a bearing such as a roughness issue or too much wear to the bearing. If the rotor speed $N_r$ is greater than the baseline rotor speed, it can be determined (630) that there is no fault related to a bearing or rotational system in motor or blockage of a pump.

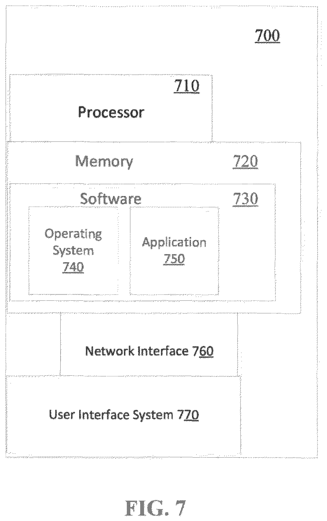

**FIG. 7** illustrates a schematic diagram illustrating components of a computing device that may be used in certain implementations described herein. The computing device can be representative of the control and monitoring unit as described herein. Referring to **FIG. 7,** computing device **700** can represent a personal computer, a reader, a mobile device, a personal digital assistant, a wearable computer, a smart phone, a tablet, a laptop computer, a gaming device, or console, an entertainment device, a hybrid computer, a desktop computer, or a smart television. Accordingly, more or fewer elements described with respect to computing device **700** may be incorporated to implement a particular computing device.

The computing device **700** can include at least one processor **710,** a memory **720,** software **730** that includes operating system **740** and application **750,** network interface **760,** and user interface **770.** Processor **710** processes data according to instructions of software **730.** The instructions of application **750** may be loaded into computing device **700** and run on or in association with the operating system **740.** Application **750** can include the methods as described. Memory **720** may comprise any computer readable storage media readable by processor **710** and capable of storing software including application **750.**

Computing device **700** can further include a user interface **770,** which may include input/output (I/O) devices and components that enable communication between a user and the computing device **700.** Computing device **700** may also include a network interface 660 that allows the system to communicate with other computing devices, including server computing devices and other client devices, over a network.

Certain embodiments of the illustrated methods include the following:

Clause 1. A computer-implemented method to identify rotor slot harmonics in a motor current spectrum of an AC induction motor, comprising: receiving current data from the AC induction motor operated at two different load values; obtaining a motor current frequency spectrum comprising a first motor current spectrum corresponding to a first load value and a second motor current spectrum corresponding to a second load value; detecting a number of peak current values for a frequency range of the motor current frequency spectrum; and comparing the detected number of peak current values for the frequency range from the first motor current spectrum to the second motor current spectrum by: determining a pair of consecutive peak current values from the detected number of peak current values, the pair of consecutive peak current values include a first peak current value for the first load value and a second peak current value for the second load value; calculating a difference between the first peak current value and the second peak current value; comparing the difference to a threshold value; and in response to the difference being greater than zero and less than the threshold value, identifying the pair of consecutive peak current values as rotor slot harmonics.

Clause 2. The method of clause 1, wherein the first load value is a first current, iL1, and the second load value is a second current, iL2.

Clause 3. The method of clause 1 or 2, further comprising determining that rotor slot harmonics are present in the motor current frequency spectrum for the AC induction motor prior to obtaining the motor current frequency spectrum.

Clause 4. The method of clause 3, wherein determining that rotor slot harmonics are present in the motor current spectrum for the induction motor includes determining that an equation is satisfied, wherein NR is a number of rotor bars, pp is a number of pole pairs, $\alpha$ = 1, 2, 3, ..., and = -1, 0, 1.

Clause 5. The method of any of the preceding clauses, wherein obtaining a current frequency spectrum for the two different load values includes performing a FFT on the received current data from the induction motor operated at the two different load values to produce the first motor current spectrum corresponding to the first load value and the second motor current spectrum corresponding to the second load value.

Clause 6. The method of any of the preceding clauses, wherein detecting the number of peak current values for a frequency range of the motor current frequency spectrum includes: calculating a mean value from a plurality of current values within the frequency range; comparing each current value of the plurality of current values to the mean value; and in response to the comparison of the current value being above a threshold value, detecting the current value as a peak current value.

Clause 7. The method of any of the preceding clauses, further comprising storing the identified rotor slot harmonics as a baseline measurement in a memory of a computer readable storage medium.

Clause 8. The method of any of the preceding clauses, further comprising verifying identified peak current values are rotor slot harmonics by determining a difference between two consecutive peak current values from a same load value, wherein the two consecutive peak current values for the same load value include the first peak current value for the first load value and a third peak current value for the first load value or the second peak current value for the second load and a fourth peak current value for the second load and in response to the difference between the consecutive peak current values being two times a supply frequency, verifying that the identified current peaks are rotor slot harmonics.

Clause 9. The method of any of the preceding clauses, wherein a motor drive of the AC induction motor is coupled to one of a variable frequency drive and a DOL soft starter.

Clause 10. A method to determine a fault of an induction motor system, comprising: driving a load by an induction motor; measuring a current of the load driven by the induction motor; estimating a rotor speed of the induction motor; performing a first comparison by comparing the measured current of the load to a baseline load current; performing a second comparison by comparing the estimated rotor speed of the induction motor to a baseline rotor speed wherein the baseline rotor speed is estimated using identified rotor slot harmonics; and determining a fault of the induction motor system based on the first comparison and the second comparison.

Clause 11. The method of clause 10, wherein the rotor slot harmonics are identified by: receiving current data from an induction motor operated at two different load values; obtaining a motor current frequency spectrum comprising a first motor current spectrum corresponding to a first load value and a second motor current spectrum corresponding to a second load value; detecting a number of peak current values for a frequency range of the motor current frequency spectrum; and comparing the detected number of peak current values for the frequency range from the first motor current spectrum to the second motor current spectrum by: determining a pair of consecutive peak current values from the detected number of peak current values, the pair of consecutive peak current values include a first peak current value for the first load value and a second peak current value for the second load value; calculating a difference between the first peak current value and the second peak current value; comparing the difference to a threshold value; and in response to the difference being greater than zero and less than the threshold value, identifying the pair of consecutive peak current values as rotor slot harmonics.

Clause 12. The method of any of the preceding clauses, wherein determining a fault of the induction motor system includes: in response to the measured current of the load being less than the baseline load current from the first comparison and the estimated rotor speed of the induction motor being greater than the baseline rotor speed from the second comparison, determining a cavitation/leakage fault.

Clause 13. The method of any of the preceding clauses, wherein determining a fault of the induction motor includes: in response to the measured current of the load being greater than the baseline load current from the first comparison and the estimated rotor speed of the induction motor being less than the baseline rotor speed from the second comparison, determining a rotational/blockage fault.

Clause 14. The method of any of the preceding clauses, wherein determining a fault of the induction motor system includes: in response to the measured current of the load being greater than the baseline load current from the first comparison, performing a winding fault test to determine a winding fault.

Clause 15. The method of any of the preceding clauses, wherein determining a fault of the induction motor system includes: in response to the measured current of the load being greater than the baseline load current from the first comparison, performing a broken rotor bar fault test to determine a broken rotor bar fault.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts that would be recognized by one skilled in the art are intended to be within the scope of the claims.

## Claims

1. A computer-implemented method to identify rotor slot harmonics in a motor current spectrum of an AC induction motor, comprising:

    receiving current data from the AC induction motor operated at two different load values;
    obtaining a motor current frequency spectrum comprising a first motor current spectrum corresponding to a first load value and a second motor current spectrum corresponding to a second load value;
    detecting a number of peak current values for a frequency range of the motor current frequency spectrum; and
    comparing the detected number of peak current values for the frequency range from the first motor current spectrum to the second motor current spectrum by:

        determining a pair of consecutive peak current values from the detected number of peak current values, the pair of consecutive peak current values include a first peak current value for the first load value and a second peak current value for the second load value;
        calculating a difference between the first peak current value and the second peak current value;
        comparing the difference to a threshold value; and
        in response to the difference being greater than zero and less than the threshold value, identifying the pair of consecutive peak current values as rotor slot harmonics.

2. The method of claim 1, wherein the first load value is a first current, $i_{L1}$, and the second load value is a second current, $i_{L2}$.

3. The method of claim 1, further comprising determining that rotor slot harmonics are present in the motor current frequency spectrum for the AC induction motor prior to obtaining the motor current frequency spectrum.

4. The method of claim 3, wherein determining that rotor slot harmonics are present in the motor current spectrum for the induction motor includes determining that an equation $N_R = 2p_p(3\alpha + \kappa)$ is satisfied, wherein $N_R$ is a number of rotor bars, $p_p$ is a number of pole pairs, $\alpha = 1, 2, 3, ...$, and $\kappa = -1, 0, 1$.

5. The method of claim 1, wherein obtaining a current frequency spectrum for the two different load values includes performing a FFT on the received current data from the induction motor operated at the two different load values to produce the first motor current spectrum corresponding to the first load value and the second motor current spectrum corresponding to the second load value.

6. The method of claim 1, wherein detecting the number of peak current values for a frequency range of the motor current frequency spectrum includes:

    calculating a mean value from a plurality of current values within the frequency range;
    comparing each current value of the plurality of current values to the mean value; and
    in response to the comparison of the current value being above a threshold value, detecting the current value as a peak current value.

7. The method of claim 1, further comprising storing the identified rotor slot harmonics as a baseline measurement in a memory of a computer readable storage medium.

8. The method of claim 1, further comprising verifying identified peak current values are rotor slot harmonics by determining a difference between two consecutive peak current values from a same load value, wherein the two consecutive peak current values for the same load value include the first peak current value for the first load value and a third peak current value for the first load value or the second peak current value for the second load and a fourth peak current value for the second load and in response to the difference between the consecutive peak current values being two times a supply frequency, verifying that the identified current peaks are rotor slot harmonics.

9. The method of claim 1, wherein a motor drive of the AC induction motor is coupled to one of a variable frequency drive and a DOL soft starter.

**10.** A method to determine a fault of an induction motor system, comprising:

driving a load by an induction motor;
measuring a current of the load driven by the induction motor;
estimating a rotor speed of the induction motor;
performing a first comparison by comparing the measured current of the load to a baseline load current;
performing a second comparison by comparing the estimated rotor speed of the induction motor to a baseline rotor speed wherein the baseline rotor speed is estimated using identified rotor slot harmonics: and
determining a fault of the induction motor system based on the first comparison and the second comparison.

**11.** The method of claim 10, wherein the rotor slot harmonics are identified by:

receiving current data from an induction motor operated at two different load values;
obtaining a motor current frequency spectrum comprising a first motor current spectrum corresponding to a first load value and a second motor current spectrum corresponding to a second load value;
detecting a number of peak current values for a frequency range of the motor current frequency spectrum; and
comparing the detected number of peak current values for the frequency range from the first motor current spectrum to the second motor current spectrum by:

determining a pair of consecutive peak current values from the detected number of peak current values, the pair of consecutive peak current values include a first peak current value for the first load value and a second peak current value for the second load value;
calculating a difference between the first peak current value and the second peak current value;
comparing the difference to a threshold value; and
in response to the difference being greater than zero and less than the threshold value, identifying the pair of consecutive peak current values as rotor slot harmonics.

**12.** The method of claim 10, wherein determining a fault of the induction motor system includes: in response to the measured current of the load being less than the baseline load current from the first comparison and the estimated rotor speed of the induction motor being greater than the baseline rotor speed from the second comparison, determining a cavitation/leakage fault.

**13.** The method of claim 10, wherein determining a fault of the induction motor includes: in response to the measured current of the load being greater than the baseline load current from the first comparison and the estimated rotor speed of the induction motor being less than the baseline rotor speed from the second comparison, determining a rotational/blockage fault.

**14.** The method of claim 10, wherein determining a fault of the induction motor system includes: in response to the measured current of the load being greater than the baseline load current from the first comparison, performing a winding fault test to determine a winding fault.

**15.** The method of claim 10, wherein determining a fault of the induction motor system includes: in response to the measured current of the load being greater than the baseline load current from the first comparison, performing a broken rotor bar fault test to determine a broken rotor bar fault.

100
130
120
M
Variable Frequency Drive 110
Power Unit 140
Control and Monitoring Unit 150
User Interface 160

FIG. 1

200
230
220
M
DOL Soft Starter
210
Starter
240
Control and
Monitoring
Unit 250
User
Interface
260

FIG. 2

300
Receiving current data from the induction motor for two different load values
310
Obtaining a motor current frequency spectrum
320
Detecting a number of peak current values for a frequency range of the motor current frequency spectrum
330
Determining a pair of consecutive peak current values
340
Calculating a difference between the first peak current value and the second peak current value
350
Comparing the difference to a threshold value
360
Identifying the pair of consecutive peak current values as rotor slot harmonics
370

FIG. 3

400
5 Nm
10 Nm
15 Nm
20 Nm
X 1112
Y -25.07
X 1125
Y -35.13
X 1138
Y -39.06
X 1145
Y -39.12
X 1212
Y -25.86
X 1225
Y -34.37
X 1238
Y -38.3
X 1245
Y -42.69
-20
-30
-40
-50
-60
-70
-80
1100
1120
1140
1160
1180
1200
1220
1240
1260
1280

**FIG. 4**

500
DOL Operated Induction Motor
Load - 1
Load - 2
Current Magnitude (A)
0.1
0.09
0.08
0.07
0.06
0.05
0.04
0.03
0.02
0.01
0
Frequency (Hz)
1000
1050
1100
1150
1200
1250
1300
1350
1400
1450
1500
X 1013.4
Y 0.0351271
X 1015.7
Y 0.0299635
X 1133.4
Y 0.0609837
X 1135.8
Y 0.0383229
X 1253.4
Y 0.0175054
X 1255.8
Y 0.0179357
X 1373.4
Y 0.0734396
X 1375.8
Y 0.0697506
X 1495.8
Y 0.0327187
X 1493.4
Y 0.0254438

FIG. 5

600
602
Measure load current IL
604
Compare the present load current IL with a baseline load current, ILb
606
IL > ILb ?
No
608
IL < ILb ?
610
System is operating normally
Yes
612
Nr > Nrb?
No
616
No cavitation or leakage
614
Yes
Cavitation or leakage determined
Yes
618
Winding fault?
Yes
620
Winding fault determined
No
622
Broken rotor bar fault?
Yes
624
Broken rotor bar fault detected
626
No
Nr < Nrb?
No
628
No fault related to bearing or rotational system in motor or blockage in pumps
Yes
630
Fault related to bearing or rotational system in motor or blockage of pumps detrmined

FIG. 6

700
710
Processor
Memory
720
Software
730
Operating
System
740
Application
750
Network Interface 760
User Interface System 770

FIG. 7

Europäisches
Patentamt
European
Patent Office
Office européen
des brevets

# EUROPEAN SEARCH REPORT

Application Number
EP 24 19 6529

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 11 411 521 B2 (MITSUBISHI ELECTRIC RES LABORATORIES INC [US]) 9 August 2022 (2022-08-09) * the whole document * ----- | 1-15 | INV. H02P1/02 G01R31/34 H02P29/024 H02P29/032 |
| A | RAY SUSANTA ET AL: "Development of a Comprehensive Analytical Model of Induction Motor Under Stator Interturn Faults Incorporating Rotor Slot Harmonics", IEEE TRANSACTIONS ON INDUSTRIAL ELECTRONICS, IEEE SERVICE CENTER, PISCATAWAY, NJ, USA, vol. 70, no. 2, 11 April 2022 (2022-04-11), pages 2037-2047, XP011922500, ISSN: 0278-0046, DOI: 10.1109/TIE.2022.3165294 [retrieved on 2022-04-12] * the whole document * ----- | 1-15 | |
| A | US 2012/001580 A1 (ZHANG PINJIA [US] ET AL) 5 January 2012 (2012-01-05) * the whole document * ----- | 1-15 | TECHNICAL FIELDS SEARCHED (IPC) H02P G01R |

The present search report has been drawn up for all claims

| Place of search | Date of completion of the search | Examiner |
|---|---|---|
| Munich | 30 January 2025 | Roussel, Maxime |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 19 6529

This annex lists the patent family members relating to the patent documents cited in the above-mentioned European search report. The members are as contained in the European Patent Office EDP file on The European Patent Office is in no way liable for these particulars which are merely given for the purpose of information.

30-01-2025

| Patent document cited in search report | Publication date | Patent family member(s) | Publication date |
|---|---|---|---|
| US 11411521 B2 | 09-08-2022 | CN 116325483 A | 23-06-2023 |
| | | DE 112021005428 T5 | 10-08-2023 |
| | | JP 2023542056 A | 04-10-2023 |
| | | KR 20230058715 A | 03-05-2023 |
| | | US 2022123680 A1 | 21-04-2022 |
| | | WO 2022079947 A1 | 21-04-2022 |
| US 2012001580 A1 | 05-01-2012 | NONE | |

EPO FORM P0459

For more details about this annex : see Official Journal of the European Patent Office, No. 12/82